**Europäisches Patentamt**

(19) **European Patent Office**

**Office européen des brevets**

(11) **EP 1 501 197 A1**

(12) **EUROPEAN PATENT APPLICATION**

(43) Date of publication:
26.01.2005 Bulletin 2005/04

(51) Int Cl.⁷: **H03M 7/46**, H03M 5/14,
G11B 20/10

(21) Application number: **04300147.8**

(22) Date of filing: **17.03.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(30) Priority: **06.06.2003 EP 03012954**

(71) Applicant: **Thomson Licensing S.A.
92100 Boulogne-Billancourt (FR)**

(72) Inventors:
 • **Kochale, Axel
 31832 Springe (DE)**

 • **Gaedke, Klaus
 30659 Hannover (DE)**
 • **Timmermann, Friedrich
 30823 Garbsen (DE)**
 • **Theis, Oliver
 32689 Kalletal (DE)**

(74) Representative: **Rossmanith, Manfred, Dr.
Deutsche Thomson-Brandt GmbH
European Patent Operations
Karl-Wiechert-Allee 74
30625 Hannover (DE)**

(54) **Bits recovery method and apparatus for an asymmetric data channel**

(57)    The present invention relates to a method for bit recovery in an asymmetric data channel.

According to the invention, the method comprises the steps of:

- providing a non-linear equalization filter with two coefficient sets;

- using the non-linear equalization filter with a first coefficient set for compensating defects of a first type of transition between different storage states; and
- using the non-linear equalization filter with a second coefficient set for compensating defects of a second type of transition between different storage states.

Fig. 4

**Description**

The present invention relates to a method and a device for bit recovery in an asymmetric data channel, and to an apparatus for reading from and/or writing to recording media using such method or device.

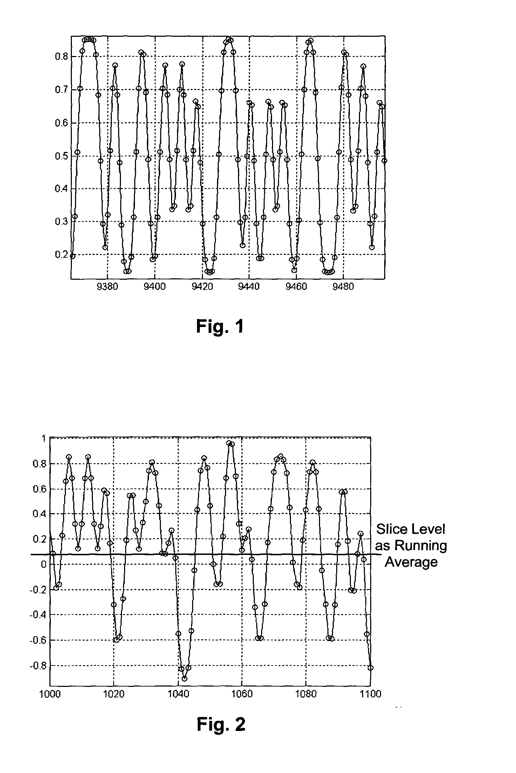

In current harddisk and optical disk applications partial response maximum likelihood detectors (PRML, Viterbi) are used for recovering the data from a channel data stream. Fig. 1 shows high frequency channel data representing a data stream from an exemplary optical channel signal. The channel data are not distorted by asymmetry. In this case a data slicing process is easily able to distinguish between two different signal states (high and low). However, the data patterns recorded on a recording medium may be distorted by an asymmetric data writing procedure. For example, on optical recording media one reason for asymmetry is Blooming, which is caused by non-linear effects during data recording. Fig. 2 shows an example of a channel data stream deteriorated by strong signal asymmetry. Due to the asymmetry a simple slicing algorithm is not able to properly distinguish between data bits representing digital high or low, since adaptive equalization means fail. This problem becomes worse when noise is present. In order to properly recover the channel data from this signal a compensation scheme is needed.

Usually a digitised optical channel data stream is resynchronised to the channel clock using a phase locked loop (PLL) and a sample rate converter (SRC), then equalized with a filter setting representing the inverse channel behaviour and finally detected using a simple slicer and a bit detector .

An adaptive approach using a maximum likelihood decoder calculates the difference of the recovered data to the equalized data, e.g. with the least mean square (LMS) method, and uses this as adjusting information in order to get a coefficient set for the equalizer, which better fits to the channel characteristic. The LMS updating is typically implemented as follows:

$$\text{Coeff}_{new} = \text{Coeff}_{old} + \mu \times \varepsilon \ (\text{filtered vit}_{out} ,\text{eq}_{out}) \times \text{channel data}$$

However, some approaches only consider the direction (+ or - ) of the error signal $\varepsilon$.

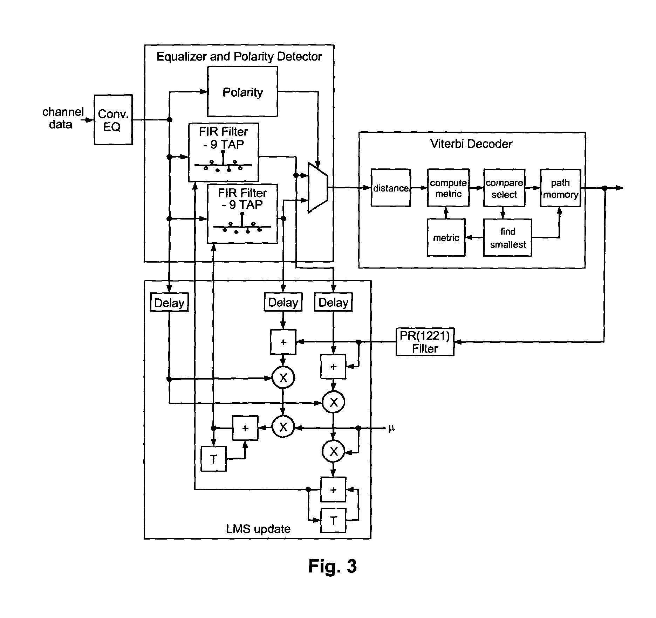

It has been found that the cause of signal asymmetry shows different behaviour during a transition from one storage state (e.g. land) to another storage state (e.g. pit). By separately compensating both transition defects a better signal data representation is found for decoding the contained data bits using a maximum likelihood approach. Fig. 3 shows an advanced version of the above scheme, which makes use of this finding by adjusting a separate equalizer for each edge of the incoming data signal.

It is an object of the invention to improve the methods known from prior art.

According to the invention, a method for bit recovery in an asymmetric data channel comprises the steps of:

- providing a non-linear equalization filter with two coefficient sets;
- using the non-linear equalization filter with a first coefficient set for compensating defects of a first type of transition between different storage states; and
- using the non-linear equalization filter with a second coefficient set for compensating defects of a second type of transition between different storage states.

The invention combines the usage of a non-linear equalization filter with means for compensating both transitions separately. Adopting the separate adaptation processes to a non-linear equalization approach greatly improves the data detection using maximum likelihood decoders.

Favourably, the equalizer scheme is implemented at least twice in parallel. In this way it supports faster channel data streams. Alternatively, it is designed as a single circuit recalculating the new sample by working on different phases of a system clock.

According to a first implementation of the inventive solution, the system clock is faster than twice the channel clock. In this case the two coefficient sets may be switched over. According to a second implementation, the system clock is slower than twice the channel clock. In this case the switching is accomplished on different system clock phases.

Usually the modulation of a channel data stream is subject to certain runlength restrictions. This allows to use a slower system clock, since some calculations are no longer required.

The method or the device are advantageously used in an apparatus for reading from and or writing to optical recording media. However, they can be applied to any other signal detection means dealing with asymmetric signal distortions.

For a better understanding of the invention, an exemplary embodiment is specified in the following description with reference to the figures. It is understood that the invention is not limited to this exemplary embodiment and that specified features can also expediently be combined and/or modified without departing from the scope of the present invention. In the figures:

Fig. 1    shows a channel signal without asymmetry;

Fig. 2    shows a channel signal with asymmetry;

Fig. 3    shows an approach using an equalizer with a dual adaptive filter;

Fig. 4    shows a solution according to the invention using an equalizer with a single filter but two coefficient sets;

Fig. 5    shows the differences between signals generated by the dual equalizer and Viterbi decoded data;

Fig. 6    shows the digital sum value (DSV) of the recovered data compared with the reference data;

Fig. 7    shows a signal level distribution of the channel data; and

Fig. 8    shows the signal level distribution after equalization.

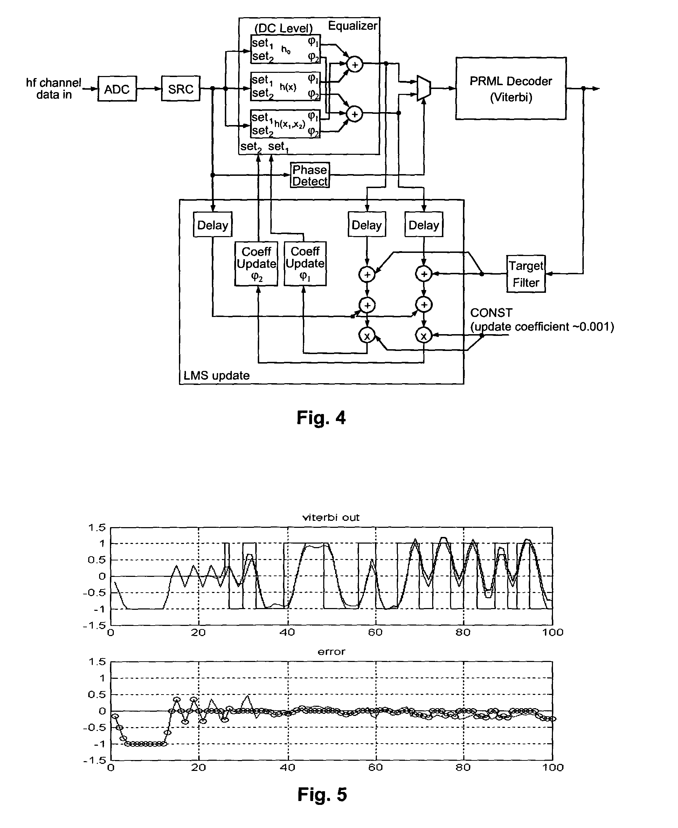

In Fig. 4 a solution according to the invention using an equalizer with a single filter but two coefficient sets is shown. Instead of an FIR filter a polynomial filter (Volterra Filter), which is simplified to an additional DC level and a multiplier to create a quadratic filter stage, is used. The algorithm representing the non-linear filter can be expressed with the following (simplified) equation 1:

$$y_k = h_0 + h_1(x(k)) + h_2(x(k),x(k)) \tag{1}$$

The known approach using an FIR filter only considers the term $h_1(x(k))$. The polyphase term $h_2$, which is basically a quadrature of the incoming signal, requires an additional DC compensation, which is taken into account by the factor $h_0$.

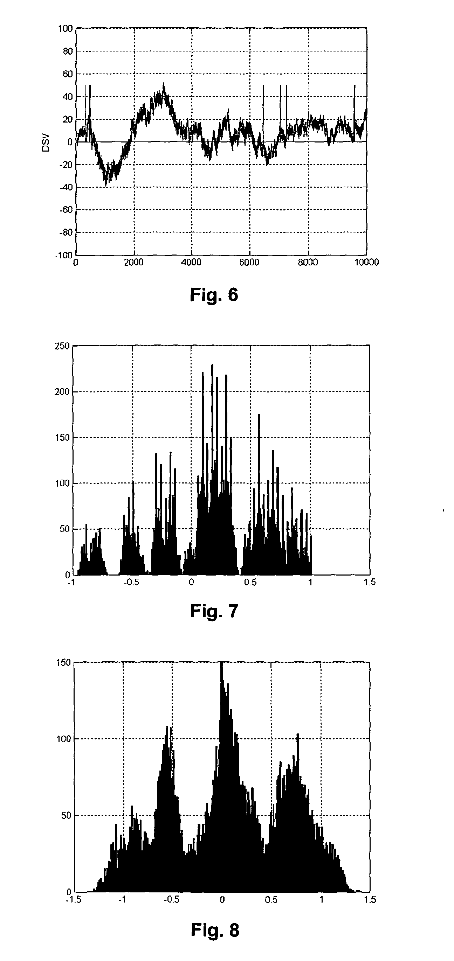

Fig. 5 to Fig. 8 show simulation results obtained with the solution according to the invention. In Fig. 5 the differences between signals generated by the dual equalizer and Viterbi decoded data. Fig. 6 compares the digital sum value (DSV) of the recovered data with the reference data. In the graph, errors in data recovery are indicated as vertical bars. In Fig. 7 a signal level distribution of the channel data is shown. For comparison Fig. 8 shows the signal level distribution after equalization.

**Claims**

1.   Method for bit recovery in an asymmetric data channel including the steps of:

   -   providing a non-linear equalization filter with two coefficient sets;
   -   using the non-linear equalization filter with a first coefficient set for compensating defects of a first type of transition between different storage states; and
   -   using the non-linear equalization filter with a second coefficient set for compensating defects of a second type of transition between different storage states.

2.   Method according to claim 1, **characterized in that** the non-linear equalization filter with two coefficient sets is implemented at least twice in parallel.

3.   Method according to claims 1 or 2, **characterized in that** the non-linear equalization filter is a Volterra filter.

4.   Method according to claim 3, **characterized in that** the Volterra filter includes a DC Compensator, a linear FIR and a quadratic term.

5.   Device for bit recovery in an asymmetric data channel, **characterized in that** it includes a non-linear equalization filter with two coefficient sets, whereby the non-linear equalization filter is used with a first coefficient set for compensating defects of a first type of transition between different storage states and with a second coefficient set for compensating defects of a second type of transition between different storage states.

6. Device according to claim 5, **characterized in that** the non-linear equalization filter with two coefficient sets is implemented at least twice in parallel.

7. Device according to claims 5 or 6, **characterized in that** the non-linear equalization filter is a Volterra filter.

8. Device according to claim 7, **characterized in that** the Volterra filter includes a DC Compensator, a linear FIR and a quadratic term.

9. Apparatus for reading from and/or writing to recording media, **characterized in that** it uses a method according to anyone of claims 1 to 4 or includes a device according to anyone of claims 5 to 8 for bit recovery in an asymmetric data channel.

**Fig. 1**

Slice Level
as Running
Average

**Fig. 2**

**Fig. 3**

**Fig. 4**

**Fig. 5**

**Fig. 6**

**Fig. 7**

**Fig. 8**

**European Patent Office**

**EUROPEAN SEARCH REPORT**

Application Number

EP 04 30 0147

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | SEOK JUN KO ET AL: "A robust digital timing recovery with asymmetry compensator for high speed optical drive systems" IEEE TRANSACTIONS ON CONSUMER ELECTRONICS, IEEE INC. NEW YORK, US, vol. 47, no. 4, 20 August 2001 (2001-08-20), pages 821-830, XP002237635 ISSN: 0098-3063 * the whole document * | 1-9 | H03M7/46 H03M5/14 G11B20/10 |
| X | US 6 449 110 B1 (BLISS WILLIAM G ET AL) 10 September 2002 (2002-09-10) * column 4, line 21 - column 5, line 30 * * column 6, line 18 - column 11, line 30 * * figures 4,6,7A,7B * | 1-9 | |
| A | POZIDIS H ET AL: "A SIMPLE NONLINEAR MODEL FOR THE OPTICAL RECORDING CHANNEL" ICC 2000. 2000 IEEE INTERNATIONAL CONFERENCE ON COMMUNICATIONS. CONFERENCE RECORD. NEW ORLEANS, LA, JUNE 18-21, 2000, IEEE INTERNATIONAL CONFERENCE ON COMMUNICATIONS, NEW YORK, NY: IEEE, US, vol. 1 OF 3, 18 June 2000 (2000-06-18), pages 99-103, XP001042920 ISBN: 0-7803-6284-5 * the whole document * | 1-9 | TECHNICAL FIELDS SEARCHED (Int.Cl.7) H03M G11B |
| A | WO 02/43340 A (BROADCOM CORP ;AGAZZI OSCAR E (US)) 30 May 2002 (2002-05-30) * page 1, line 10 - page 3, line 11 * * page 5, line 3 - line 8 * * page 5, line 32 - line 36 * * page 6, line 6 - page 11, line 14 * * page 13, line 17 - line 18 * * page 13, line 24 - page 17, line 15 * * figures 4,5,13,14A,14B,15 * | 1-9 | |

-/--

The present search report has been drawn up for all claims

| Place of search | Date of completion of the search | Examiner |
|---|---|---|
| Munich | 20 October 2004 | Barel-Faucheux, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 04 30 0147

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 2002/060827 A1 (AGAZZI OSCAR E) 23 May 2002 (2002-05-23) * the whole document * | 1-9 | |
| A | GOPALASWAMY S ET AL: "DESISION-DERECTED CORRECTION FOR BLOOM IN OPTICAL RECORDING CHANNELS" JAPANESE JOURNAL OF APPLIED PHYSICS, PUBLICATION OFFICE JAPANESE JOURNAL OF APPLIED PHYSICS. TOKYO, JP, vol. 39, no. 2B, PART 1, February 2000 (2000-02), pages 834-836, XP001051387 ISSN: 0021-4922 * the whole document * | 1-9 | |
| A | HANGYU CHO ET AL: "Combining nonlinear equalization and simple detection for high-density optical recording channels" IEEE TRANSACTIONS ON MAGNETICS, IEEE INC. NEW YORK, US, vol. 38, no. 5, September 2002 (2002-09), pages 2313-2315, XP002237636 ISSN: 0018-9464 * the whole document * | 1-9 | TECHNICAL FIELDS SEARCHED (Int.Cl.7) |

The present search report has been drawn up for all claims

| Place of search | Date of completion of the search | Examiner |
|---|---|---|
| Munich | 20 October 2004 | Barel-Faucheux, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                     EP 04 30 0147

This annex lists the patent family members relating to the patent documents cited in  the above-mentioned European search report.
The members are as contained in the European Patent Office EDP file on
The European Patent Office is in no way liable for these particulars which are merely  given for the purpose of information.

20-10-2004

| Patent document cited in search report | | Publication date | Patent family member(s) | | Publication date |
|---|---|---|---|---|---|
| US 6449110 | B1 | 10-09-2002 | NONE | | |
| WO 0243340 | A | 30-05-2002 | AU | 2693302 A | 03-06-2002 |
| | | | EP | 1344361 A2 | 17-09-2003 |
| | | | WO | 0243340 A2 | 30-05-2002 |
| | | | US | 2002060827 A1 | 23-05-2002 |
| US 2002060827 | A1 | 23-05-2002 | AU | 2693302 A | 03-06-2002 |
| | | | EP | 1344361 A2 | 17-09-2003 |
| | | | WO | 0243340 A2 | 30-05-2002 |

EPO FORM P0459

For more details about this annex : see Official Journal of the European Patent Office, No. 12/82